# EUROPEAN PATENT APPLICATION

(11) **EP 4 832 279 A1**
(43) Date of publication of application: **28.10.2026**
(21) Application number: 26173830.6
(22) Date of filing: 21.04.2026
(51) Int. Cl.: H02H 1/00, G01R 31/08, H02H 3/44, H02H 3/38

(54) **SYSTEMS AND METHODS FOR MONITORING ELECTRICAL ARCING**

(30) Priority: 21.04.2025 US 202563792217 P
(71) Applicant: Erico International Corporation, Solon, OH 44139 (US)
(72) Inventor: Frackelton, Brian, Macedonia (US); Hussain, Hasan, Cleveland (US); Martinjak, Greg, Solon (US)
(74) Representative: Barker Brettell LLP

(57) **Abstract**

The disclosed technology provides an improved electrical monitoring system (100) for an electrical system. The electrical monitoring system can include an electrical conductor, a sensor (106, 108), and a memory (118). A plurality of values can be measured from the electrical conductor via the sensor. A plurality of differences between each value of the plurality of values and a corresponding reference value can be determined. Each difference of the plurality of differences can be compared with a threshold. It can be determined if an arc event has occurred based on the comparison.

## Description

### BACKGROUND

Arcing events can occur when electrical current jumps across a gap. Arcing events may be associated with poor electrical connections, breakdown in insulation, or power surges experienced by electrical components.

### SUMMARY

The present disclosure relates to monitoring arcing events in an electrical system and, in particular, to improved systems and methods for identifying and diagnosing arcing events.

According to an aspect of the present disclosure, an electrical monitoring system for an electrical system is provided. The electrical monitoring system includes an electrical conductor configured to provide power to the electrical system. The electrical monitoring system includes a sensor electrically connected to the electrical conductor. The electrical monitoring system includes a processor in communication with the sensor. The electrical monitoring system includes a memory in communication with the processor and having instructions stored thereon that, when executed, cause the processor to measure, via the sensor, a plurality of values from the electrical conductor, determine a plurality of differences between each value of the plurality of values and a corresponding reference value, compare each difference of the plurality of differences with a threshold, and determine if an arc event has occurred based on the comparison.

In some examples, the sensor includes a voltage sensor.

In some examples, the sensor further includes a current sensor.

In some examples, the electrical monitoring system further includes a surge protection device.

In some examples, the memory has further instructions stored thereon that, when executed, cause the processor to, as part of determining if the arc event has occurred, record a number of differences that fall outside of the threshold, wherein the arc event is determined to have occurred when the number reaches a predetermined limit.

In some examples, the electrical monitoring system further includes a wireless communication module, wherein the memory has further instructions stored thereon that, when executed, cause the processor to send an alert, via the wireless communication module, to a remote device, indicating that the arc event has occurred.

In some examples, the arc event is a series arcing event.

In some examples, the electrical monitoring system further includes an electrical converter configured to rectify the plurality of values, wherein the memory has further instructions stored thereon that, when executed, cause the processor to determine the plurality of differences based on the rectified plurality of values.

In some examples, the electrical monitoring system further includes a real-time clock in communication with the processor, wherein the memory has further instructions stored thereon that, when executed, cause the processor to record, via the real-time clock, one or more time values associated with the determined arc event.

In some examples, the memory has further instructions stored thereon that, when executed, cause the processor to detect an increase in arc event occurrences over a time period based on the recorded one or more time values, and send an alert to a remote device based on detecting the increase in arc event occurrences.

According to another aspect of the present disclosure, a method of monitoring an electrical system for electrical arcing is provided. The method includes obtaining a plurality of voltage values from an electrical conductor. The method includes calculating a plurality of differences between each voltage value of the plurality of voltage values and a neighboring voltage value in the plurality of voltage values. The method includes comparing each difference of the plurality of differences to a threshold. The method includes counting a number of differences from the plurality of differences that exceed the threshold. The method includes determining an arc event has occurred based on the number of differences.

In some examples, the threshold defines a mean change in voltage for a voltage waveform corresponding to the plurality of voltage values.

In some examples, the method further includes recording a time value associated with the determined arc event, and detecting an increase in arc event occurrences over a time period based on the recorded time value.

In some examples, a value of the threshold changes based on a sample rate of sensors used to obtain the plurality of voltage values.

In some examples, a value of the threshold is manually entered by a user.

According to another aspect of the present disclosure, a method of detecting electrical arcing in an electrical system is provided. The method includes obtaining, via a sensor, a plurality of current values from an electrical conductor. The method includes identifying a frequency spike in the plurality of current values. The method includes analyzing the frequency spike to determine if an arc event has occurred. The method includes outputting an alert indicating the arc event has occurred.

In some examples, analyzing the frequency spike includes calculating a plurality of differences between each current value in the plurality of current values and a neighboring value in the plurality of current values, and comparing each difference of the plurality of differences to a threshold.

In some examples, analyzing the frequency spike further includes counting a number of differences from the plurality of differences that exceed the threshold.

In some examples, the method further includes recording, via a real-time clock, a time value associated with the arc event, and detecting an increase in arc event occurrences over a time period based on recorded time values.

In some examples, the method further includes classifying the arc event as one of a short circuit arcing event or a load arcing event based on a magnitude and a frequency corresponding to the plurality of current values.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. One or more features described in connection with the electrical monitoring system or any feature(s) or component(s) described may have corresponding feature(s) definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate examples of the invention and, together with the description, serve to explain the principles of examples of the invention.
FIG. 1 is a schematic block diagram of an example system for monitoring electrical arcing, according to the present disclosure.
FIG. 2 is a circuit diagram of an example arc monitoring system, according to the present disclosure.
FIG. 3 is an example flowchart for performing arc event detection, according to some examples.
FIGS. 4-8 show temporal voltage and current plots that illustrate operation of examples of the disclosed systems.

### DETAILED DESCRIPTION

Before any examples of the disclosed technology are explained in detail, it is to be understood that the disclosed technology is not limited in its application to the details of construction and the arrangement of components set forth in the following description or illustrated in the following drawings. The disclosed technology is capable of other implementations and of being practiced or of being carried out in various ways. Also, it is to be understood that the phraseology and terminology used herein is for the purpose of description and should not be regarded as limiting.

The following discussion is presented to enable a person skilled in the art to make and use examples of the disclosed technology. Various modifications to the illustrated examples will be readily apparent to those skilled in the art, and the generic principles herein can be applied to other examples and applications without departing from the disclosed technology. Thus, the disclosed technology are not intended to be limited to examples shown, but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of examples of the disclosed technology. Skilled artisans will recognize the examples provided herein have many useful alternatives that also fall within the scope of the disclosed technology.

As noted above, systems and methods described herein can be used within electrical systems to identify and respond to arcing events. Generally, an electrical system may utilize switches, relays, or the like to shut off power when an electrical system experiences conditions representative of an arcing event. In some examples, an arcing event may occur as a result of poor installation on electrical conduit, vibrations, heat cycling, poor connections or the like.

Examples of the disclosed technology may provide an improved design for identifying, as well as gaining insight as to a frequency and source of, arcing events. For example, some implementations can monitor current or voltage in an electrical circuit over time, and compare the monitored values to reference values (e.g., a fixed, common reference value, or variable reference values) to determine whether an arcing event - and particularly an undesirable arcing event - has occurred. Some implementations in particular can monitor voltage over time, and identify potential arcing based sampled voltages exceeding a reference circuit voltage by more than a threshold value. For example, potential arcing can be identified based on a difference between a voltage measured at time, *t,* and a voltage measured previously at time, *t - t₀,* exceeding a threshold value (e.g. in particular, based on an accumulation of a threshold number of the excessive voltages over a single voltage cycle or multiple voltage cycles). In some implementations, sampled current can be similarly used, including by comparing current magnitudes to appropriate thresholds or by assessing frequency characteristics of the current (e.g., identifying arcing based on introduction of higher frequencies or other changes to frequency distributions, as compared to a reference value or profile).

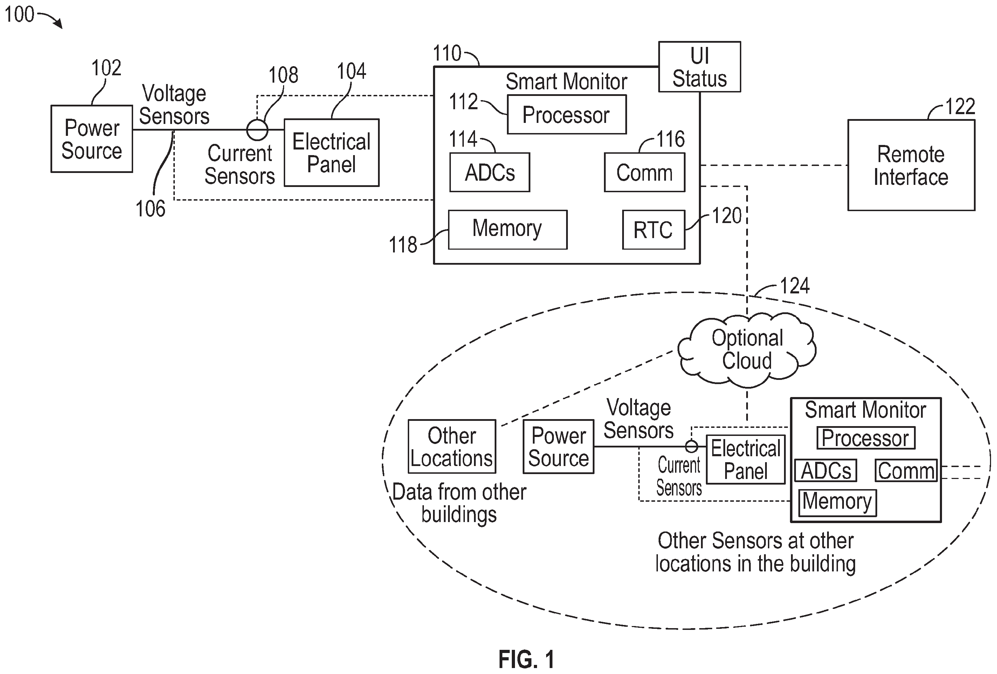

Referring to FIG. 1, an example system 100 that can be used to monitor and detect arcing events is shown. In the illustrated example, the arc detection system 100 includes a power source 102, an electrical panel 104, one or more voltage sensors 106, one or more current sensors 108, and a smart monitor 110. As illustrated in FIG. 1, the one or more voltage sensors 106 and the one or more current sensors 108 can measure a voltage or current value between the power source 102 and the electrical panel 104. As shown in FIG. 1, the one or more voltage sensors 106 and the one or more current sensors 108 may be connected to the smart monitor 110.

In some examples, the sensor 106, 108 may further record a time or date associated with each measurement. For example, the sensors 106, 108 may utilize a real-time clock (RTC) 120 or a standard network time protocol (SNTP) server. For example, a user may define an interval, such as a date or a time of day, in which the sensors 106, 108 are to obtain measurements, which can be used to detect outages within the system 100.

In some examples, the one or more voltage sensors 106 and the one or more current sensors 108 may be installed on each phase, to measure line voltage and line current, respectively. In some examples, each of the one or more voltage sensors 106 and the one or more current sensors 108 may be used to detect a specific phase in which the respective sensor is installed on. For example, the one or more voltage sensors 106 and the one or more current sensors 108 may detect if their respective phases are the same or different from the other sensors installed in the system 100. In some examples, only one of the types of sensors 106, 108 may be used (e.g., for a particular line).

In some examples, a sensor such as a rectifier, voltage divider, or analog-to-digital converter may be used to measure and monitor voltage. Moreover, in some examples, a current transformer or analog-to-digital converter may be used to measure and monitor current. In some examples, the sensors 106, 108 may obtain measurements at predetermined or predicted time intervals to determine a phase angle of their respective phase connection.

In some examples, the power source 102 may be supplied by a utility company. For example, the power source 102 may be a local power grid, which the electrical panel 104 is connected to via overhead or underground power lines. In further examples, the power source 102 may include one or more solar panels, generators, or the like. The electrical panel 104 may distribute power received from the power source 102 to a connected residential, commercial, or industrial building, facility, or property. In some examples, the electrical panel 104 may be a sub-panel that distributes power to a portion of a connected building, facility, or property.

As mentioned above, the one or more voltage sensors 106 and the one or more current sensors 108 may be connected to the smart monitor 110. In some examples, the one or more voltage sensors 106 and the one or more current sensors 108 may be hardwired to the smart monitor 110 using a cable or other communication link. In further examples, the one or more voltage sensors 106 and the one or more current sensors 108 may be wirelessly connected to the smart monitor 110 via Bluetooth, cellular signals, wi-fi, or the like. In some examples, the one or more voltage sensors 106, the one or more current sensors 108, and the smart monitor 110 may be a single unit. For example, the one or more voltage sensors 106, the one or more current sensors 108, and the smart monitor may be embedded into a surge protection device or may be a stand-alone device installed at a meter or electrical panel 104.

As illustrated in FIG. 1, the smart monitor 110 may include a processor 112, one or more analog-to-digital converters (ADCs) 114, a communications module 116, a memory 118, and the RTC 120. In some examples, the processor 112 may control when the one or more voltage sensors 106 and the one or more current sensors 108 obtain readings. Moreover, any readings obtained by the one or more voltage sensors 106 and the one or more current sensors 108 may be stored in the memory 118.

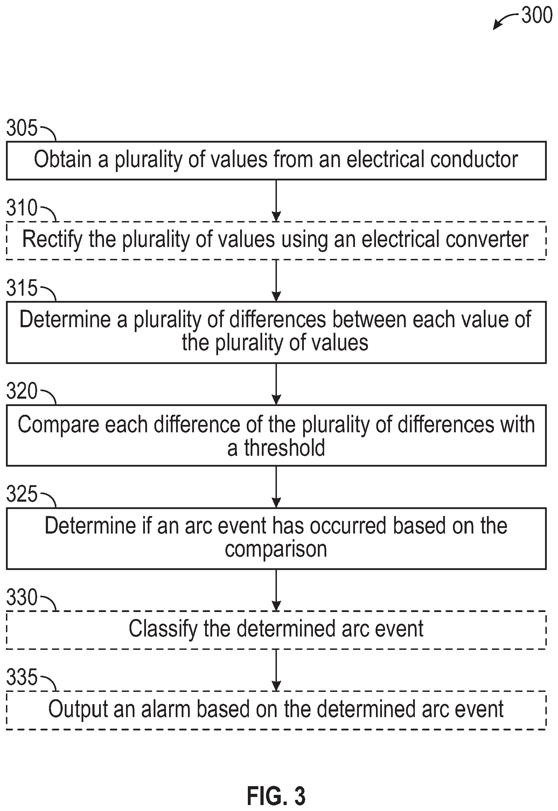

As described below with respect to FIG. 3, the smart monitor 110 may include instructions stored on the memory 118 that allow the smart monitor 110 to perform arc event detection. In some examples, the memory 118 may further store instructions thereon that track an escalation of arcing event occurrences. For example, the smart monitor may detect an increase in arcing event occurrences at a piece of equipment and initiate an alert or notification in response to this detection. Moreover, in some examples, the smart monitor 110 may record timestamps associated with each detected arcing event and analyze the frequency of events within defined time windows (e.g., per hour, per day, or per week). In some examples, the smart monitor 110 may calculate an average of arcing event occurrences and compare the current frequency to a historical baseline to detect an increasing trend. In some examples, the smart monitor 110 may additionally or alternatively track the magnitude of detected arcing events, such as by recording the peak voltage or current associated with each event. The smart monitor 110 may detect an escalation when the magnitude of events increases over time, such as when an average magnitude over a recent time period exceeds an average magnitude over a prior baseline period by more than a threshold percentage. In some examples, the notification or alert may identify a location (e.g., a breaker position, a transformer, or a position associated with a faulty piece of equipment) in the system 100 where an increase in arcing events occurred, therefore identifying, with the alert, that remediation may be required.

In some examples, the smart monitor 110 may receive a pulse communication from the sensors 106, 108 to determine an approximate electrical distance within the system 100. In some examples, the memory 118 may store instructions that cause the smart monitor 110 to identify patterns in failures of one or more devices connected to the system 100. In some examples, the patterns in failures may indicate a failure of one or more components within the system 100. For example, the smart monitor 110 may detect an electrical transient on a power line, using measurements obtained from the sensors 106, 108. Moreover, the smart monitor 110 may compare the detected electrical transient to a transient profile saved in the memory 118. For example, a difference between the measurements from the sensors 106, 108 and the transient profile may indicate an early detection of failure within the system 100. The transient profile may include voltage, current, or power measurements. In some examples, the smart monitor 110 may further determine a geolocation associated with the identified location of an arcing event to categorize an occurrence with respect to a physical location within the system 100.

In some examples, the processor 112 can be any suitable hardware processor or combination of processors, such as a central processing unit (CPU), a graphics processing unit (GPU), and so on. The processor 112 may analyze signals from the one or more voltage sensors 106 and the one or more current sensors 108 based on instructions stored in the memory 118. In some examples, the ADCs 114 may be utilized when analyzing the signals. For example, one or more current measurements may be accessed as analog signals by the ADCs 114 for conversion to digital values. In some examples, the signals from the one or more voltage sensors 106 and the one or more current sensors 108 can be received from the memory 118 or other suitable data storage device or medium.

Moreover, the processor 112 may communicate the processed signals to a remote interface 122 via the communications module 116. For example, the communications module 116 may transmit signals, and any information corresponding to detected arcing events, to the remote interface 122 via a wired or wireless connection. In some examples, the remote interface 122 is a display that can include any suitable display devices, such as a liquid crystal display (LCD) screen, a light-emitting diode (LED) display, an organic LED (OLED) display, an electrophoretic display, a computer monitor, a touchscreen, a television, and so on. In other examples, the remote interface 122 can be any suitable computing device or combination of devices, such as a laptop computer, a smartphone, a desktop computer, a tablet computer, a server computer, a virtual machine being executed by a physical computing device, a cloud resource, a set of GPUs, or the like.

As further illustrated in FIG. 1, the arc detection system 100 may include an optional communication connection 124 with other sensors, panels, buildings, etc. For example, the communications module 116 may receive a library of detected arcing events or sensor values from other arc detection systems. In some examples, the other arc detections systems may correspond to additional panels or sub-panels within the same facility, building, or location as the electrical panel 104.

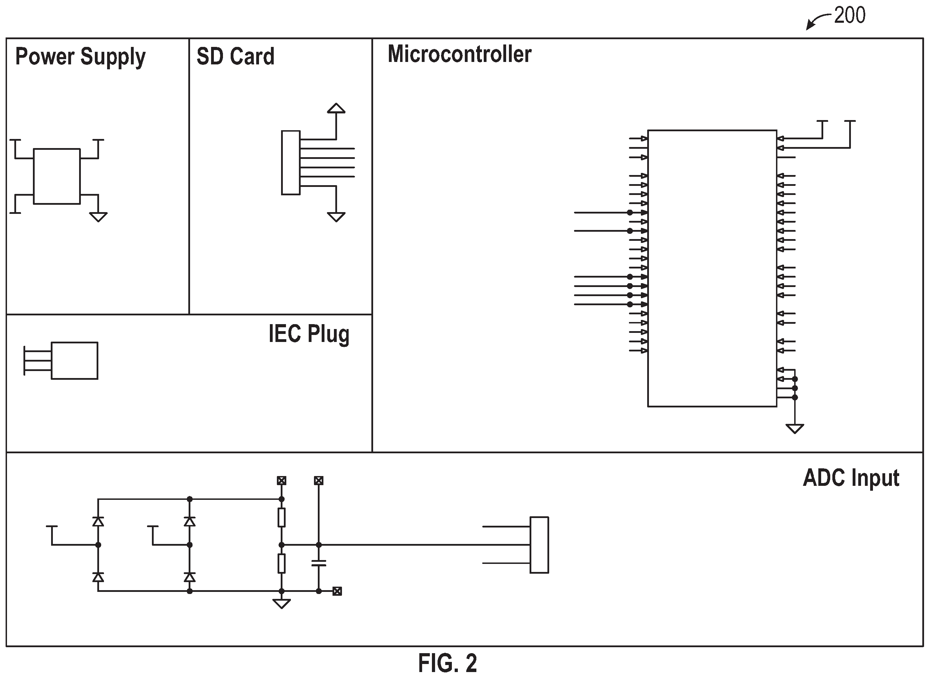

In some examples, the smart monitor 110 and other components within the arc detection system 100 may be integrated into a larger electrical system, such as additional sensors, panels, buildings, etc. connected via the optional communication connection 124. For example, the arc detection system 100 may further utilize both local data (e.g., data obtained from sensors 106 and 108), as well as regional data (e.g., data obtained from equipment external to system 100). In some examples, the regional data may identify arc events detected in other electrical systems powered by the same utility power source. FIG. 2 illustrates an example circuit diagram 200 of the arc detection monitor system 100. As illustrated in FIG. 2, the example circuit diagram 200 includes a microcontroller 302, a secure digital (SD) card 304, a power supply 206, an international electrotechnical commission (IEC) plug 208, and an ADC input 210.

FIG. 3 is a flow diagram illustrating an example process 300 for performing arc event detection, according to some examples. As described below, a particular implementation can omit some or all illustrated features/blocks, may be implemented in some examples in a different order, and may not require some illustrated features to implement all examples. In some examples, an apparatus (e.g., smart monitor 110) in connection with FIG. 1 can be used to perform all or part of example process 300. However, it should be appreciated that other suitable processing hardware for carrying out the operations or features described below may perform process 300.

At block 305, a plurality of values is obtained from an electrical conductor. For example, as described above with respect to FIG. 1, the plurality of values may include voltage values obtained using the one or more voltage sensors 106, or current values obtained using the one or more current sensors 108. In some examples, the plurality of values may represent voltage or current waveforms, frequency readings, or the like. In some examples, the plurality of values may include values from multiple phases (e.g., each phase) or a single phase of an electrical system.

At block 310, process 300 optionally rectifies the plurality of values using an electrical converter. For example, as described above with respect to FIG. 1, the plurality of values may include alternating current (AC) values, therefore, the ADCs 114 may convert the plurality of values to direct current (DC) values. In some examples, rectification may include dividing the plurality of values into one or more samples based on a frequency (e.g., 50kHz or 60kHz), a number of cycles, or the like.

At block 315, a plurality of differences between each value of the plurality of values is determined. In some examples, the differences are determined chronologically. For example, each value in a waveform may be subtracted from a preceding, subsequent, or other neighboring value to determine a corresponding difference and a plurality of differences between neighboring values (e.g., neighboring voltage values) thus determined. In some examples, block 315 can alternatively (or additionally) included determining differences relative to other values (e.g., a modeled or historical profile for current or voltage for a particular system). In some examples, the plurality of values may be compared to measurement profiles of a similar or same equipment type. For example, the measurement profile may represent an ideal performance of a device connected to the electrical conductor.

At block 320, each difference of the plurality of differences is compared with a threshold value. In some examples, the threshold may be a mean value or range of values representing an expected difference value. For example, a threshold value may specify a maximum or other current or a voltage (e.g., 10mV) by which a sampled current or voltage waveform is expected to change from one sample to the next. In some examples, the threshold value may accordingly change based on a sampling rate of sensors used to obtain the plurality of values, or a frequency (e.g., 50kHz or 60kHz) of the rectified plurality of values. In some examples, the threshold may represent a characteristic of a normal cycle or frequency composition for the electrical system. For example, the characteristic may include a peak voltage or peak current value observed during a normal operation cycle, a rate of change of voltage or current during normal zero-crossings of an AC waveform, or the like. In some examples, the threshold value may be automatically determined by a system (e.g., system 100), or a user may manually enter in a desired threshold value for a system.

In some examples, the threshold value may be determined based on characteristics of the electrical system being monitored. In some examples, the threshold value may be calibrated during an initial learning period in which the system monitors normal operating conditions and establishes baseline voltage or current change rates. For example, the system may sample voltage values over multiple AC cycles during known non-arcing conditions and calculate a statistical baseline (e.g., a mean plus two or three standard deviations) to establish the threshold. In some examples, the threshold may be adjusted based on the impedance characteristics of the monitored circuit, the distance from the electrical panel to connected loads, or the types of loads connected to the circuit (e.g., resistive loads versus inductive loads such as motors).

At block 325, it can be determined if an arc event has occurred, e.g., based on the comparison at block 320. In some examples, the determination may be performed using one or more methodologies described herein. For example, the plurality of differences exceeding a current or voltage threshold value may represent sudden abrupt shifts in current or voltage values caused by an arcing event. As another example, occurrence of an arc event may be determined at block 325 based on a comparison of frequency values. For example, arcing may be determined if frequency values (e.g., obtained via a Fourier transform of a current signal) are determined to be different from a reference frequency value or range (e.g., a particular frequency threshold value or range). In other words, determined differences that indicate a frequency that is higher than a characteristic frequency (e.g., specified by a relevant current threshold) may indicate an arcing event.

In some examples, the process 300 may determine an arcing event has occurred when several differences of the plurality of differences fall outside of the threshold. For example, the process 300 may utilize a predetermined limit, which specifies a number of times (e.g., 40 times) that a difference falling outside of the threshold is detected. A count corresponding to differences falling outside of the threshold may be reset after a certain time frame has elapsed (e.g., after one or more waveform cycles have passed). In some examples, the predetermined limit may automatically be set or determined by a system, or a user may manually enter the predetermined limit value.

At block 330, the process 300 optionally classifies the arcing event. In some examples, the arcing events may be classified as either a short circuit arcing event or a load arcing event. A short circuit arcing event may be characterized by a high magnitude current spike occurring over a short duration of time. For example, a short circuit arcing event may be detected based on a current value exceeding a high current threshold within a window of time. In some examples, a short circuit arcing event may exhibit a rapid rise time in the current waveform, which the system may detect based on a rate of change of current exceeding a rate threshold. Moreover, a load arcing event may be characterized by low magnitude fluctuations in the current over a long duration of time. In some examples, a load arcing event may be detected based on repetitive or intermittent current spikes that occur at an interval corresponding to an AC waveform cycle. In some examples, a load arcing event may exhibit characteristic high frequency noise superimposed on the fundamental frequency, which the system may detect via frequency distribution analysis.

Moreover, in some examples, the classification of arcing events may be based on distinguishing electrical characteristics. For example, series arcing events, which occur when a conductor is partially severed or a connection is loose, may exhibit characteristic shoulder patterns in the current waveform near zero-crossings, where the current momentarily drops to zero before the arc reestablishes. Parallel arcing events, which occur between line and neutral or line and ground conductors, may exhibit higher magnitude current spikes and may be accompanied by corresponding voltage sags. In some examples, the system may distinguish arcing events from normal electrical transients, such as those caused by a motor starting, a relay switching, or a capacitor bank energization. For example, a motor starting may cause a transient that exhibit a characteristic inrush current pattern that decays over several cycles as the motor reaches operating speed, whereas arcing events may exhibit more erratic, non-decaying patterns. In some examples, the system may utilize a time-frequency analysis to identify the broadband noise signature characteristic of arcing, which differs from the discrete frequency components typically associated with switching transients or harmonic distortion form electronic loads. In further examples, a severity of the arcing event may be classified based on a magnitude and frequency corresponding to an input transient waveform. For example, the process 300 may identify certain devices operating within the electrical system that may be contributing to an arcing event. For example, the process 300 may identify a transformer operating within the electrical system, allowing a user or technician to review possible events or damages to the transformer, prior to the occurrence of the arcing event. In some examples, patterns in detected arcing events may be determined using a machine learning model, or via manual observation by a user. Moreover, in some examples, data corresponding to the plurality of values, plurality of differences, and the detected arcing events may be sent to a remote cloud server for analysis and classification. In some examples, the classification of arcing events may further utilize data obtained from other sensors, such as surge protective devices (SPDs).

At block 335, the process 300 optionally outputs an alarm based on the determined arc events, or takes other remedial action. In some examples, the alarm may notify a user of an arcing event occurrence, as well as provide diagnostic information regarding the source of the arcing event or arcing event mitigation suggestions. As described above with respect to FIG. 1, the alarm may be sent to a remote interface 122 via the smart monitor system 110. For example, the alarm may generate a notification on a personal cellular device or a remote server capable.

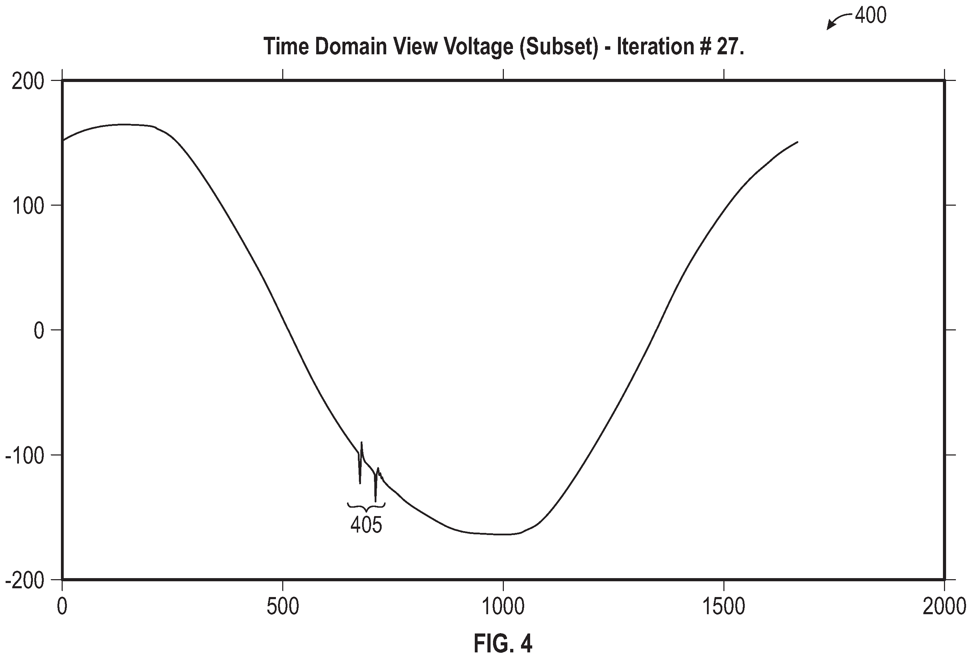

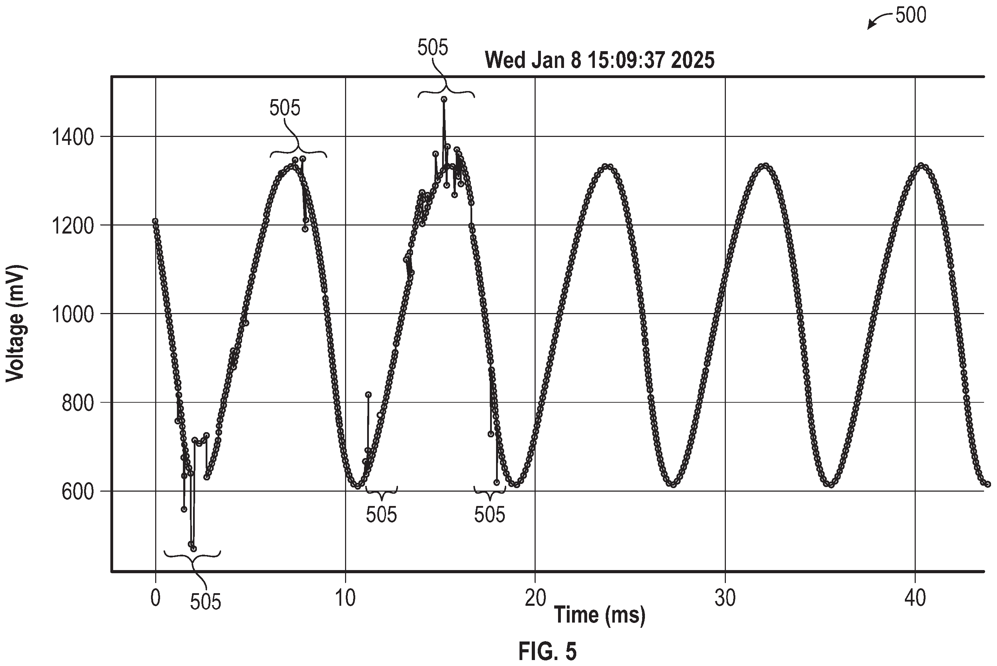

FIGS. 4 and 5 illustrate example voltage waveforms 400, 500 in the time domain, containing one or more potential arcing events 405, 505. The voltage waveforms 400, 500 illustrate voltage values that may be monitored for abrupt, notable changes (e.g., as detailed above). In some examples, the waveforms 400, 500 may correspond to the plurality of voltage values from an electrical conductor used through the process 300, as described above with respect to FIG. 3. For example, the values corresponding to the one or more arcing events 405, 505 may include a change (i.e., a difference) in subsequent voltage values that fall outside of the threshold. Accordingly, for example, upon identifying a particular number of these differences (e.g., under block 325, above), it can be determined that an arcing event has occurred.

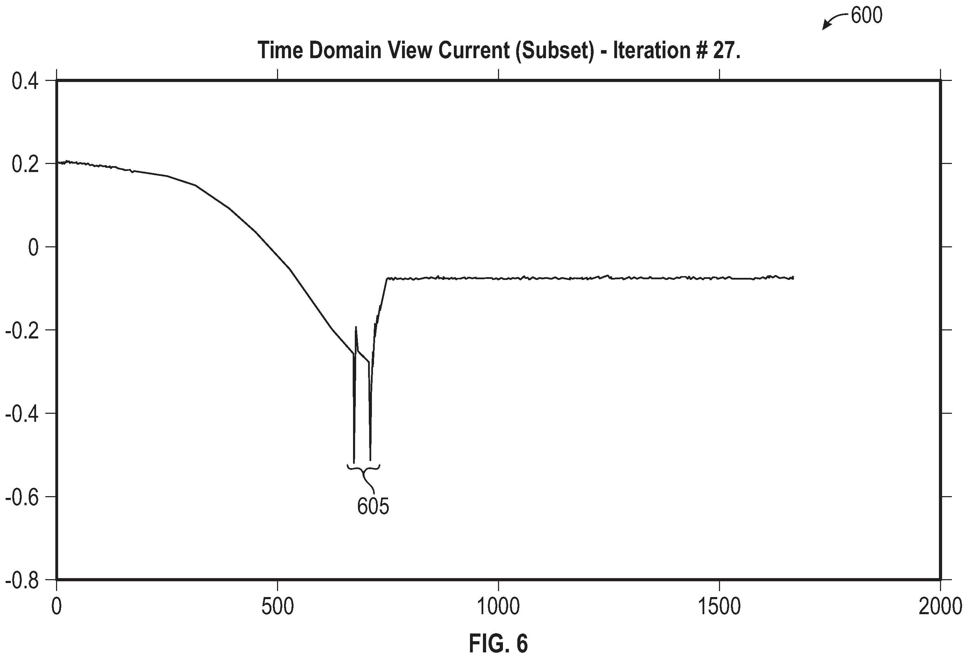

As mentioned above, the determination of whether an arcing event has occurred may be performed using frequency measurements, current measurements, voltage measurements, energy measurements, or a combination thereof. FIGS. 6-8 illustrate various waveforms and measurements that may be used in such a determination. For example, FIG. 6 illustrates a current waveform 600 in the time domain, containing an arcing event 605. In some examples, the arc event 605 may be characterized by and determined by identifying an abrupt, notable shift in current values. Moreover, as shown in the example of FIG. 6, it may be possible to identify arcing via sampling and analysis of only voltage (e.g., not current). In some examples, the current waveform 600 may exhibit a rapid transition or discontinuity at the arcing event 605, which may be characterized by a rate of change of current that exceeds a rate threshold. Moreover, in some examples, the magnitude of the current deviation at the arcing event 605 may be used to classify a severity of an arcing event. For example, a larger magnitude deviation may indicate a short circuit arcing event, while a smaller magnitude deviation may indicate a load arcing event.

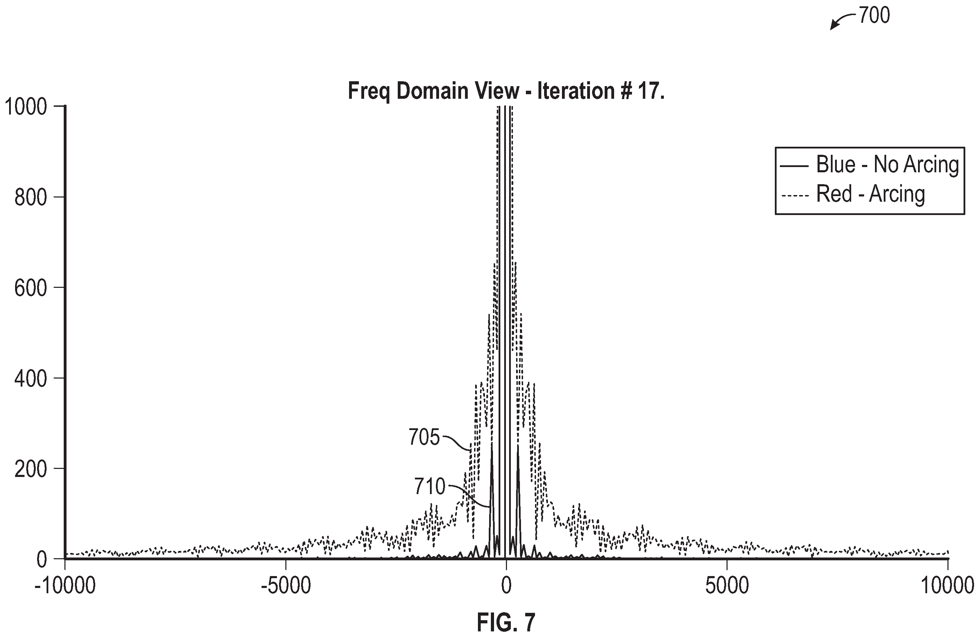

FIG. 7 illustrates a frequency distribution plot 700 of both a current during an arcing event 705 and a current during a non-arcing event 710. In some examples, the systems and methods described herein may determine an arcing event has occurred based on a spread of a frequency distribution plot (e.g., with a corresponding difference in represented frequencies differing from a threshold value). For example, as shown, current measurements may expose high frequency spikes that may be used to identify one or more points-of-interest in time. Moreover, voltage measurements corresponding to the one or more points-of-interest in time may be obtained to discern whether an arc has occurred. In some examples, this correlation technique may allow the system to focus computation resources on specific time windows where arcing is more likely to have occurred. Accordingly, high frequency components in the current signal may serve as an indicator to trigger additional examination of corresponding voltage data, which may provide additional confirmation or characterization of a potential arcing event. In some examples, the frequency distribution plot 700 may be generated using a Fourier transform or other frequency analysis technique applied to the current signal. As illustrated in FIG. 7, the current of the non-arcing event 710 may exhibit a narrow frequency distribution concentrated near a fundamental frequency (e.g., 60 Hz or 50 Hz), while the current of the arcing event 705 may exhibit a broader frequency distribution with elevated amplitude values extending across a wider frequency range. In some examples, the system may compare a calculated spread to a frequency spread threshold to determine whether an arcing event has occurred.

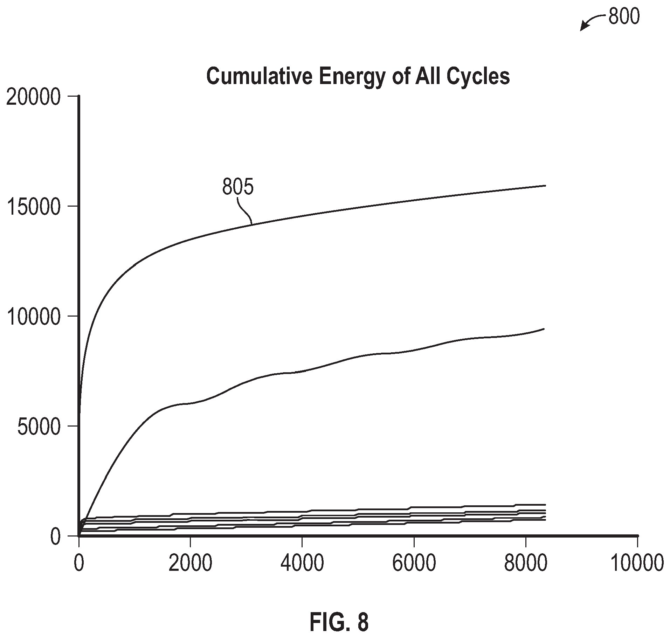

FIG. 8 illustrates an example plot 800 of a cumulative energy based on monitored current values throughout one or more cycles (e.g., with energy at 60Hz removed to better emphasize contributions of other frequencies). In some examples, the systems and methods described herein may determine an arcing event has occurred based on an increase in cumulative energy, as shown by cycle 805 (e.g., based on the cumulative energy exceeding a particular threshold). In some examples, the cumulative energy plot 800 may display cumulative energy values for multiple cycles, allowing comparison between cycles to identify anomalous energy accumulation. As illustrated in FIG. 8, the cycle 805 may exhibit a higher cumulative energy compared to other cycles, which may indicate the presence of an arcing event during that cycle. In some examples, the system may establish a baseline cumulative energy value based on historical data or a learning period, and may determine that an arcing event has occurred when the cumulative energy for a cycle exceeds the baseline by more than a threshold amount or threshold.

In some examples, the cumulative energy calculation may be performed by integrating the square of the current or voltage signal over one or more AC cycles. For example, the energy contribution at each sample point may be calculated as the product of the squared current value and the sampling interval, and these contributions may be summed over the duration of a cycle. In some examples, the fundamental frequency component (e.g., 60Hz or 50Hz) may be removed from the signal prior to energy calculation to emphasize the energy contribution of higher-frequency components associated with arcing. For example, a notch filter or known digital signal processing techniques may be used to remove the fundamental component. In some examples, the cumulative energy may be compared across multiple cycles, and an increase in cumulative energy above a baseline value may indicate the presence of arcing. For example, a cumulative energy value that exceeds the baseline by more than a threshold percentage (e.g., 20% or more) may trigger an arc event determination.

Thus, the disclosed electrical monitoring system can provide improved detection and diagnosis of arcing events in electrical systems. For example, systems and methods described herein can be used within electrical systems to identify and respond to arcing events, with improved approaches for identifying the occurrence of individual arcing events and patterns of arcing events over time.

The use herein of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

Unless otherwise specified or limited, the terms "about" and "approximately," as used herein with respect to a reference value, refer to variations from the reference value of ± 20% or less (e.g., ± 15, ± 10%, ± 5%, etc.), inclusive of the endpoints of the range. Similarly, as used herein with respect to a reference value, the term "substantially equal" (and the like) refers to variations from the reference value of less than ± 5% (e.g., ± 2%, ± 1%, ± 0.5%) inclusive. Where specified in particular, "substantially" can indicate a variation in one numerical direction relative to a reference value. For example, the term "substantially less" than a reference value (and the like) indicates a value that is reduced from the reference value by 30% or more (e.g., 35%, 40%, 50%, 65%, 80%), and the term "substantially more" than a reference value (and the like) indicates a value that is increased from the reference value by 30% or more (e.g., 35%, 40%, 50%, 65%, 80%).

As used herein, unless otherwise specified, ordinal numbers are used for convenience to differentiate between systems, components, etc. based on the order of introduction into the relevant text. Correspondingly, unless otherwise specified, ordinal numbers are not intended to indicate a particular sequential order, priority, or other limitation.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. One or more features of the devices and systems described may be incorporated into/used in corresponding methods and vice versa.

In some implementations, devices or systems disclosed herein can be utilized, manufactured, installed, etc. using methods embodying aspects of the disclosed technology. Correspondingly, unless otherwise indicated, any description herein of particular features, capabilities, or intended purposes of a device or system should be considered to disclose, as examples of the disclosed technology a method of using such devices for the intended purposes, a method of otherwise implementing such capabilities, a method of manufacturing relevant components of such a device or system (or the device or system as a whole), and a method of installing disclosed (or otherwise known) components to support such purposes or capabilities. Similarly, unless otherwise indicated, discussion herein of any method of manufacturing or using for a particular device or system, including installing the device or system, should be understood to disclose, as examples of the disclosed technology, the utilized features and implemented capabilities of such device or system.

The previous description of the disclosed examples is provided to enable any person skilled in the art to make or use the disclosed technology. Various modifications to these examples will be readily apparent to those skilled in the art, and the generic principles defined herein may be applied to other examples without departing from the spirit or scope of the disclosed technology. Thus, the disclosed technology is not intended to be limited to the examples shown herein but is to be accorded the widest scope consistent with the principles and novel features disclosed herein.

## Claims

1. An electrical monitoring system for an electrical system, the electrical monitoring system comprising:
an electrical conductor configured to provide power to the electrical system;
a sensor electrically connected to the electrical conductor;
a processor in communication with the sensor; and
a memory in communication with the processor and having instructions stored thereon that, when executed, cause the processor to:
measure, via the sensor, a plurality of values from the electrical conductor;
determine a plurality of differences between each value of the plurality of values and a corresponding reference value;
compare each difference of the plurality of differences with a threshold; and
determine if an arc event has occurred based on the comparison.

2. The electrical monitoring system of claim 1, wherein the sensor includes a voltage sensor.

3. The electrical monitoring system of claim 2, wherein the sensor further includes a current sensor.

4. The electrical monitoring system of any one of claims 1-3, further comprising a surge protection device.

5. The electrical monitoring system of any one of claims 1-4, wherein the memory has further instructions stored thereon that, when executed, cause the processor to, as part of determining if the arc event has occurred:
record a number of differences that fall outside of the threshold,
wherein the arc event is determined to have occurred when the number reaches a predetermined limit.

6. The electrical monitoring system of any one of claims 1-5, further comprising:
a wireless communication module,
wherein the memory has further instructions stored thereon that, when executed, cause the processor to:
send an alert, via the wireless communication module, to a remote device, indicating that the arc event has occurred.

7. The electrical monitoring system of any one of claims 1-6, wherein the arc event is a series arcing event.

8. The electrical monitoring system of any one of claims 1-7, further comprising an electrical converter configured to rectify the plurality of values;
wherein the memory has further instructions stored thereon that, when executed, cause the processor to determine the plurality of differences based on the rectified plurality of values.

9. The electrical monitoring system of any one of claims 1-8, further comprising a real-time clock in communication with the processor,
wherein the memory has further instructions stored thereon that, when executed, cause the processor to:
record, via the real-time clock, one or more time values associated with the determined arc event.

10. The electrical monitoring system of claim 9, wherein the memory has further instructions stored thereon that, when executed, cause the processor to:
detect an increase in arc event occurrences over a time period based on the recorded one or more time values; and
send an alert to a remote device based on detecting the increase in arc event occurrences.

11. A method of monitoring an electrical system for electrical arcing, the method comprising:
obtaining a plurality of voltage values from an electrical conductor;
calculating a plurality of differences between each voltage value of the plurality of voltage values and a neighboring voltage value in the plurality of voltage values;
comparing each difference of the plurality of differences to a threshold;
counting a number of differences from the plurality of differences that exceed the threshold; and
determining an arc event has occurred based on the number of differences.

12. The method of claim 11, wherein the threshold defines a mean change in voltage for a voltage waveform corresponding to the plurality of voltage values.

13. The method of either of claims 11 or 12, further comprising:
recording a time value associated with the determined arc event; and
detecting an increase in arc event occurrences over a time period based on the recorded time value.

14. The method of any one of claims 11-13, wherein a value of the threshold changes based on a sample rate of sensors used to obtain the plurality of voltage values.

15. The method of any one of claims 11-14, wherein a value of the threshold is manually entered by a user.
